Europäisches Patentamt

European Patent Office

Office européen des brevets

(11) Veröffentlichungsnummer **0 158 900**
A2

## (12) EUROPÄISCHE PATENTANMELDUNG

(21) Anmeldenummer: **85103792.9**

(22) Anmeldetag: **29.03.85**

(51) Int. Cl.⁴: **H 05 K 13/02**

(30) Priorität: **19.04.84 GB 8410251**

(43) Veröffentlichungstag der Anmeldung:
**23.10.85 Patentblatt 85/43**

(84) Benannte Vertragsstaaten:
**DE FR GB NL**

(71) Anmelder: **HERAEUS QUARZSCHMELZE GMBH**
**Quarzstrasse Postfach 1554**
**D-6450 Hanau(DE)**

(72) Erfinder: **Hayward, Geoffrey**
**165 Frimley Green Road**
**Frimley Surrey GU16 6JY(GB)**

(74) Vertreter: **Heinen, Gerhard, Dr.**
**W.C. Heraeus GmbH Zentralbereich Patente und**
**Lizenzen Heraeusstrasse 12-14**
**D-6450 Hanau(DE)**

(54) Anlage zum automatischen Beschicken einer Ofenanordnung mit Halbleiterscheiben.

(57) Es ist eine Anlage zum Beschicken einer Ofenanordnung mit Halbleiterscheiben bekannt, die mindestens zwei Wärmebehandlungskammern (1 A, B, C, D), aufweist, wobei jeder Wärmebehandlungskammer eine ortsfeste Beschickungseinheit (1) zugeordnet ist mit einer in Richtung der Ofenachse über ein Vortriebsaggregat verfahrbaren Aufnahme mit einem Trägersystem (2 A, B, C, D) für Halbleiterscheiben. Um eine Anlage zum automatischen Beschicken einer Ofenanordnung mit Halbleiterscheiben zu schaffen, die das Beschicken der Ofenanordung erleichtert und die Nachteile der bekannten Anlagen vermeidet, weist die Anlage ein für alle Halbleiter Trägersysteme (2), die von der Beschickungseinheit (8) abnehmbar sind, gemeisame zentrale Ladestationen (9) auf. Weiterhin ist eine in zwei zueinander senkrechten Richtungen und jeweils senkrecht zur Ofenachse bewegbare Transportvorrichtung (10) mit einer Kuppeleinheit (12) zur Beförderung jeweils eines mit Halbleiterscheiben beschickten Trägersystems (2) zwischen Ladestation (9) und Ofen-Beschickungseinheit (8) vorgesehen.

./...

Croydon Printing Company Ltd

Fig.1

"Anlage zum automatischen Beschicken einer Ofenanordnung mit Halbleiterscheiben"


Die vorliegende Erfindung betrifft eine Anlage zum Beschicken
einer Ofenanordnung mit Halbleiterscheiben, die mindestens
zwei Wärmebehandlungskammern, insbesondere rohrförmige Kammern,
aufweist, wobei jeder Wärmebehandlungskammer eine ortsfeste
Beschickungseinheit zugeordnet ist mit einer in Richtung
der Ofenachse über ein Vortriebsaggregat verfahrbaren Aufnahme
mit einem Trägersystem für Halbleiterscheiben.

Es wurde bereits vorgeschlagen, Halbleitersubstrate automatisch
in und aus Wärmebehandlungsöfen, die im allgemeinen Rohröfen
sind, mit Hilfe von Transportvorrichtungen zu transportieren,
die die in Magazinen aus Glas oder Keramik, normalerweise
aus Quarzglas, eingesetzten Halbleitersubstrate in horizontaler Richtung in und aus den Öfen befördern. Mehrere solcher
Rohröfen sind oftmals in Etagen übereinander angeordnet,
wobei jedem Ofen eine eigene Beschickungseinrichtung für
die Substrate zugeordnet ist.

Bis heute werden die Halbleitersubstrate manuell auf die
horizontal bewegliche Transportvorrichtung/Beschickungsvorrichtung zum Be- und Entladen der Öfen gesetzt oder davon
entnommen, was nichts anderes heißt, als daß eine Bedienungsperson,

- 2 -

die die Halbleitersubstrate enthaltenden Magazine eines nach
dem anderen mit Hilfe eines speziellen Werkzeuges, wie zum
Beispiel einer Traggabel, einsetzt oder entnimmt. Jedoch
mit der Zunahme der Substratgröße und dem damit verbundenen
zusätzlichen Gewicht wird die Verfahrensweise zunehmend unpraktischer. Außerdem ist zu fordern, das Bedienungspersonal
aus der Umgebung des Ofens und der Lade-/Entladestation soweit
wie möglich fernzuhalten, da das Bedienungspersonal als Ursache
von Verunreinigungen erkannt wurde, wodurch die Reinraumbedingungen verschlechtert und die Ausbeute der Halbleiterproduktion beeinträchtigt wird.

Eine Wärmebehandlungs-Anlage gemäß dem Oberbegriff des Anspruches
1 ist aus der DE-OS 32 37 047 bekannt. Bei dieser Wärmebehandlungs-Anlage werden die zu behandelnden Halbleiterscheiben,
die in Trägern angeordnet sind, mit einer Gabel, die Teil
einer ortsfest jedem Ofen zugeordneten Beschickungseinheit
ist, in den rohrförmigen Ofen eingefahren und wieder herausgeholt. Diese Gabel kann hierzu gesenkt und angehoben werden.

Der vorliegenden Erfindung liegt die Aufgabe zugrunde, eine
Anlage zum automatischen Beschicken einer Ofenanordnung mit
Halbleiterscheiben zu schaffen, die das Beschicken der Ofenanordnung erleichtert und die aufgezeigten Nachteile der
bekannten Anlagen vermeidet.

Diese Aufgabe wird erfindungsgemäß dadurch gelöst, daß die
Anlage eine für alle Halbleiter-Trägersysteme, die von der
Beschickungseinheit abnehmbar sind, gemeinsame zentrale Ladestation und eine in zwei zueinander senkrechten Richtungen
und jeweils senkrecht zur Ofenachse bewegbare Transportvorrichtung mit einer Kuppeleinheit zur Beförderung jeweils
eines mit Halbleiterscheiben beschickten Trägersystems zwischen
Ladestation und Ofen-Beschickungseinheit aufweist.

Ein Kern der Erfindung besteht darin, daß die Halbleiter-Trägersysteme von den Beschickungseinheiten abnehmbar sind und eine Transportvorrichtung geschaffen ist, die in zwei Richtungen bewegbar ist, um die Trägersysteme zu einer Ladestation zu bringen.

Vorzugsweise besteht die Vorrichtung aus einer Mehrzahl von Rohröfen, die etagenweise angeordnet sind, wobei jeder Rohrofen jeweils einer Transportvorrichtung zugeordnet ist, die die erfindungsgemäßen Transportbewegungen ausführt.

Jede Transportvorrichtung ist so angeordnet, daß sie entlang einer ersten Bewegungsrichtung läuft, wenn sie Substrate in den Ofen oder aus dem zugehörigen Ofen befördert; es sind ferner Mittel vorgesehen, die die Transportvorrichtung entlang einer zweiten Bewegungsrichtung befördern, und zwar senkrecht (rechtwinklig) zu der ersten Bewegungsrichtung, und die die Transportvorrichtung längs einer dritten Bewegungsrichtung verschieben, und zwar rechtwinklig zu der ersten und/oder zweiten Bewegungsrichtung. Eine Bewegung entlang des zweiten und/oder dritten Wegs wird dann gewählt, wenn Magazine, die die Halbleitersubstrate tragen, von einer Ladestation für Magazine in die unmittelbare Ofennähe oder aus der unmittelbaren Ofennähe zurück zur Ladestation gebracht werden sollen. Die Transportvorrichtungen enthalten vorteilhafterweise jeweils ein freitragendes (hängendes) Ladesystem, wie es beispielsweise in der eigenen europäischen Patentanmeldung, veröffentlicht unter der Nummer 0093504 (Anmeldungsnummer 83 301 805.4), beschrieben ist.

Gemäß der vorliegenden Erfindung sind Hilfsmittel vorgesehen, die geeignet sind, um solch ein freitragendes Ladesystem aus dem unmittelbaren Bereich des Ofens soweit zu einer Position zurückzufahren, daß es aus seiner ursprünglichen Aufhängung herausgelöst und auf eine andere Aufhängevorrichtung übertragen wird, durch die das freitragende Ladesystem wenigstens horizontal und möglicherweise auch vertikal fort von der
momentanen unmittelbaren Nähe des Ofens zu einer Substratumladestation bewegt werden kann, wo bereits wärmebehandelte
Substrate von dem freitragenden Ladesystem entnommen und
noch zu behandelnde Substrate auf das freitragende Ladesystem
aufgestellt werden können. Das freitragende Ladesystem kann
dann auf dem umgekehrten Weg bewegt werden, bis es wieder
von der Aufhängevorrichtung der Beschickungseinheit übernommen
wird, durch die es in die Öfen gefahren und wieder aus den
Öfen herausgefahren wird.

Vorteilhaft ist für horizontal angeordnete Wärmebehandlungskammern eine Anlage, bei der die Transportvorrichtung einen
vertikalen Tragearm aufweist, an dem ein horizontaler Tragearm
verfahrbar angeordnet ist, wobei an dem horizontalen Tragearm
die Kuppeleinheit horizontal verfahrbar angeordnet ist.

In einer weiteren Ausgestaltung weist das Trägersystem einen
Verbindungskopf auf, der sowohl an die Kuppeleinheit als
auch an eine Verbindungseinrichtung der Beschickungseinheit
ankuppelbar ausgebildet ist. Zum Justieren ist ein freitragendes Trägersystem mit einem Einspannkopf vorteilhaft, über
den die Neigung des Trägersystems relativ zur Ofenachse einstellbar ist, wobei der Einspannkopf Teil des Verbindungskopfes
sein kann.

Eine einfache Verstellbarkeit wird durch einen Einspannkopf
geschaffen, der zur Verstellung der Neigung des Trägersystems
Schraubelemente aufweist.

In einer vorteilhaften Anordnung ist der Verbindungskopf
ein hakenförmiges Teil, das sowohl an der Verbindungseinrichtung als auch an der Kuppeleinheit einhakbar ist. Der Verbindungskopf kann hierzu eine Plattform aufweisen mit
einer hakenförmigen Rückwand, die das hakenförmige Teil bildet.

Eine einfach betreibbare Anordnung wird durch eine Kuppeleinheit
mit einer Plattform geschaffen mit einer hiervon vorstehenden
Rückwand und einer Verbindungseinrichtung mit ebenfalls einer
Plattform mit zwei vorstehenden, voneinander beabstandeten,
einen Zwischenraum bildenden Seitenpfosten, wobei der Zwischenraum mindestens geringfügig größer als die Breite der Rückwand
der Kuppeleinheit ist, so daß die Kuppeleinheit zwischen
den beiden Seitenpfosten eingreifen kann.

Eine gute Zentrierung und sichere Halterung ergibt sich dadurch,
daß das hakenförmige Teil eine sich verengende Hakenöffnung
aufweist. Aus dem gleichen Aspekt weist die Rückwand und/oder
die Seitenpfosten an ihrer oberen, nach innen gerichteten
Kante eine Abschrägung auf und/oder an ihrer nach außen,
zum Verbindungskopf hin gerichteten Seite im unteren Bereich
eine sich keilförmig zur Plattform hin erweiternd ausgebildete
Basis.

Weitere Einzelheiten der Erfindung ergeben sich aus der nachfolgenden Beschreibung eines Ausführungsbeispieles anhand
der Zeichnungen. In der Zeichnung zeigt:

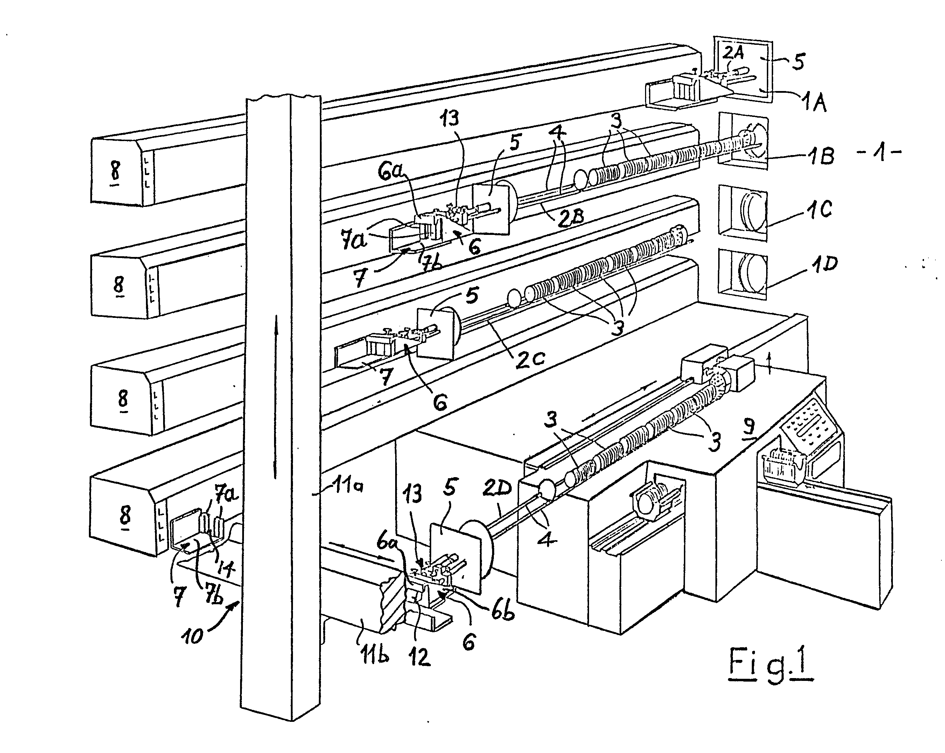

Figur 1 eine perspektivische Darstellung der erfindungsgemäßen
        Vorrichtung entsprechend der gegenwärtigen Erfindung und

Figur 2A, 2B und 2C schematisch Seiten- und Endansichten
        der Vorrichtung nach Figur 1 ausschnittsweise in
        verschiedenen Funktionsstadien

Die Vorrichtung nach Figur enthält vier in Etagen übereinander
angeordnete rohrförmige Diffusionsöfen 1A, 1B, 1C und 1D.
Jeder von ihnen ist mit einem zugeordneten freitragenden
Ladesystem 2A, 2B, 2C und 2D verknüpft und verbunden, von

0158900

denen Magazine (nicht sichtbar) mit Halbleitersubstraten 3
in die Öfen zur Wärmebehandlung geladen werden und danach
wieder aus den Öfen herausgefahren werden. Jedes der freitragenden Ladesysteme 2, das grundsäztlich, wie in unserer
vorstehend erwähnten europäischen Anmeldung beschrieben,
aufgebaut sein kann, weist zwei horizontal angeordnete Quarzglasrohre 4 auf, die parallel und so weit voneinander beabstandet sind, daß sie eine Anzahl von Magazinen aufnehmen können,
von denen jedes eine Anzahl von Halbleitersubstraten 3 für
die Wärmebehandlung aufnehmen kann, zum Beispiel 25 oder
50 Substrate pro Magazin. Die Quarzglasrohre 4 umhüllen innere
keramische Stäbe und die rückwärtigen Enden tragen einen
Hitzeschild 5 und enden in einem Verbindungskopf (Aufhängungssystem) 6, welcher trennbar an einer Verbindungseinrichtung
(Puller-Plattform) 7 angebracht ist, die horizontal hin und
her entlang einer horizontal angeordneten Ofen-Beschickungseinheit (Gehäuse) 8 verfahren kann, so daß das freitragende
Ladesystem 2 mit aufgesetzten Substraten für die Wärmebehandlung
in seinen zugeordneten Ofen 1 gefahren werden kann und nach
der Wärmebehandlung durch das freitragende Einfachrsystem
wieder aus dem Ofen zurückgezogen werden kann. Der Fahrmechanismus für jede Verbindungseinrichtung ist elektrisch angetrieben und in das Gehäuse 8 eingebaut.

Die Vorrichtung enthält auch eine Substratumladestation 9
(einen Substrat-Transfermechanismus), an der Substrate für
die Wärmebehandlung in Magazinen aufgestellt werden können,
die sich auf irgendeiner der freitragenden Ladesysteme 2
befinden, und wo die Magazine mit bereits wärmebehandelten
Substraten dann wieder entladen werden können. Außerdem ist
zwischen den etagenweise angeordneten Gehäusen 8 und dem
Substrat-Umlademechanismus 9 eine Transportvorrichtung (vertikal
angeordneter Puller-Mechanismus oder Elevator) 10 für das
Heben und Senken eines horizontal an dem vertikalen Tragearm 11a

angeordneten Tragearmes 11b vorgesehen, der eine quer angeordnete Kuppeleinheit 12 (Puller-Transfer-Support) trägt,
die zwischen der Verbindungseinrichtung 7 an der Beschickungseinheit 8 und der Substrat-Ladestation 9 verfahrbar ist.

Wenn die Wärmebehandlung der Halbleitersubstrate 3 in dem
Ofen 1 beendet ist, werden sie von den freitragenden Einfahrsystemen 2 aus dem Ofen herausgefahren und kühlen auf einer
ersten Halteposition des freitragenden Einfahrsystemes ab
(diese Position ist für das System 2B dargestellt). Sie werden
dann weiter zurück bewegt (wie dargestellt für das System 2C)
bis sie dann eine Umsetzstation D erreichen, mit einer Position
der Verbindungseinrichtung 7 am rückwärtigen Ende des Gehäuses
8 (wie dargestellt für die Verbindungseinrichtung 7 am Ofen
1D). Der horizontale Tragearm 11b wird dann angehoben - oder
gesenkt - bis auf eine Position, in der sich die Kuppeleinheit
12 in gleicher Fluchtlinie befindet wie die Verbindungseinrichtungen 7. Danach wird das freitragende Ladesystem von
der Verbindungseinrichtung 7 auf die horizontal laufende
Kuppeleinheit 12 übernommen. Die Transportvorrichtung 10
wird dann, falls notwendig, die Kuppeleinheit 12 bis auf
das Niveau der zentralen Ladestation 9 absenken und ebenfalls
das freitragende Ladesystem 2, das es jetzt trägt, horizontal
bis an eine Position verfahren, die sich auf der Ladestation
(Substrat-Transpfermechanismus) 9 befindet (wie dargestellt
für das System 2D), wonach die Magazine, die die behandelten
Substrate enthalten, entladen werden können. Nicht wärmebehandelte Substrate werden dann in die Magazine auf das
freitragende Ladesystem 2 durch den Transfermechanismus der
Ladestation 9 geladen und die horizontal verlaufende Kuppeleinheit (Support) 12 und die Transportvorrichtung 10 werden
betätigt, um das freitragende Einfahrsystem horizontal und
vertikal zu verfahren bis es an der seinem Ofen zugeordneten
Stelle an der Position der Verbindungseinrichtung 7 angelangt
ist. In dieser Position wird das freitragende Einfahrsystem
wieder auf die Verbindungseinrichtung (Puller-Plattform) 7 übertragen, die dem entsprechenden Ofen zugeordnet ist, so
daß es dann durch den Antriebsmechanismus des Pullers in
dem Gehäuse 8 wieder in den Ofen 1 befördert werden kann,
wo die Wärmebehandlung der Substrate vorgenommen wird. Die
Transportvorrichtung 10 und die Kuppeleinheit 12 werden ebenfalls
vorzugsweise elektrisch angetrieben.

Auf diese beschriebene Art arbeitet das freitragende Einfahrsystem
2 als Transportvorrichtung für die Halbleitersubstrate, die
es trägt, und zwar sowohl hin und zurück zu dem Substrat-
Transfermechanismus 9, als auch hinein und heraus aus dem
Ofen.

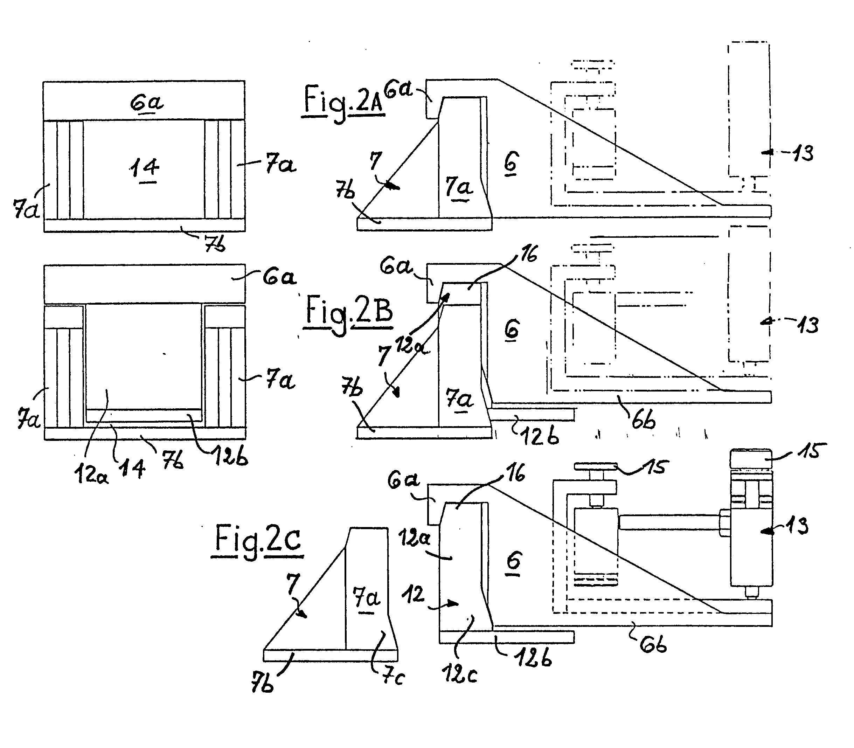

Die Figuren 2A bis 2C zeigen Schritte in der Übertragung
des Trägersystems 2 mit dem Verbindungskopf 6 zwischen der
Verbindungseinrichtung 7 und der Plattform 12b der Kuppeleinheit 12. Wie dargestellt ist, teilweise mit gestrichelten
Linien, weist das rückwärtige Ende des freitragenden Einfahrsystems einen Einspannkopf 13 für die Justierung der Einspannung
der Rohre 4 im Verhältnis zu einem Ofen auf und jeder Einspannkopf sitzt auf einer tragenden Plattform 6b mit einer hakenförmigen Rückwand 6a, die über die obere Kante von Seitenpfosten 7a auf der Verbindungseinrichtung 7 angehängt ist.
Die Plattform 12b bzw. deren Rückwand 12a der Kuppeleinheit 12
ist so bemessen, daß sie in einen Zwischenraum 14 zwischen
den Seitenpfosten 7a eingreifen kann, um so ein freitragendes
Einfahrsystem 2 bzw. 6 zu übernehmen. Speziell die Figur
2A zeigt einen Verbindungskopf mit einer tragenden Plattform
6b, die an ihrer hakenförmigen Rückwand 6a an einer Plattform
7b aufgehängt ist. Figur 2B zeigt die Plattform 12b bzw.
deren Rückwand 12a der Kuppeleinheit 12 in die Öffnung 14
hinein und aufwärts verfahren, um die hakenförmige Rückwand
6a des Verbindungskopf 6 von den Seitenpfosten 7a zu lösen.
Figur 2C zeigt, wie die Plattform 12a, 12b der Kuppeleinheit
12 das freitragende Einfahrsystem bereits trägt, indem es
sich mit der hakenförmigen Rückwand 6a verhakt hat, um so
den Verbindungskopf 6 in einer Querbewegung von der

- 9 -

Verbindungseinrichtung 7 fortzutragen. Es ist verständlich, wie die Übertragung eines freitragenden Systems von der Kuppeleinheit 12 zu irgendeiner der Verbindungseinrichtungen in der gleichen, nur umgekehrten Weise stattfindet.

Es ist ebenfalls ersichtlich, daß eine Vorrichtung, wie oben beschrieben, bestehend aus etagenweise angeordneten Öfen und verknüpft mit freitragenden Ladesystemen, so programmiert oder gesteuert werden kann, daß die freitragenden Ladesysteme hin zu einem Substrat-Transfermechanismus 9 und zurück und ebenfalls in Öfen hinein und heraus aus diesen Öfen in jeder gewünschten Abfolge bewegt werden können. Es können zahlreiche andere Zuordnungen im Rahmen der beschriebenen Erfindung möglich sein; die hier beschreibene Zurodnung stellt nur eine der möglichen Beispiel dar.

Das Verfahren und die Vorrichtung der vorliegenden Erfindung besitzt folgende hervorzuhebende Vorteile:

a) Die freitragenden Einfahrsysteme sind mechanisch sehr stark und stabil und stellen deshalb eine sichere und zuverlässige Transportmöglichkeit dar, mit der die sehr empfindlichen und sehr kostbaren Halbleitersubstrate von einer Stelle zu einer anderen, d.h. von einer Ladestation zu einem Ofen und umgekehrt befördert werden können.

b) Eine direkte Übertragung der Substrate auf Magazine, die wiederum auf den freitragenden Einfahrsystemen stehen, bedeutet, daß weniger individuelle Hebe- und Übertragungsoperationen notwendig sind verglichen mit dem Fall, in dem die Substrate indirekt auf die freitragenden Einfahrsysteme übertragen werden, wie dies bisher erfolgte; hierdurch werden weniger Partikel (Verunreinigungen) freigesetzt.

- 10 -

d) Die Vorrichtung kann so ausgelegt und aufgestellt werden, daß sie automatisch arbeitet, ohne daß beim Betrieb die Anwesenheit von Bedienungspersonal erforderlich ist, das durch die Anwesenheit die Reinraumverhältnisse im Bereich der Ladestation stören würde.

e) Durch die leichte Entfernbarkeit der freitragenden Ladesysteme von den Verbindungseinrichtungen 7 der Puller sind die Öfen stets leicht für routinemäßig notwendige Wartungsmaßnahmen zugänglich.

**0158900**


"Anlage zum automatischen Beschicken einer Ofenanordnung mit Halbleiterscheiben"


1. Anlage zum Beschicken einer Ofenanordnung mit Halbleiterscheiben, die mindestens zwei Wärmebehandlungskammern,
insbesondere rohrförmige Kammern, aufweist, wobei jeder
Wärmebehandlungskammer eine ortsfeste Beschickungseinheit
zugeordnet ist mit einer in Richtung der Ofenachse über
ein Vortriebsaggregat verfahrbaren Aufnahme mit einem
Trägersystem für Halbleiterscheiben, dadurch gekennzeichnet,
daß die Anlage eine für alle Halbleiter-Trägersysteme
(2), die von der Beschickungseinheit (8) abnehmbar sind,
gemeinsame zentrale Ladestation (9) aufweist und eine
in zwei zueinander senkrechten Richtungen und jeweils
senkrecht zur Ofenachse bewegbare Transportvorrichtung
(10) mit einer Kuppeleinheit (12) zur Beförderung jeweils
eines mit Halbleiterscheiben beschickten Trägersystems
(2) zwischen Ladestation (9) und Ofen-Beschickungseinheit
(8).

2. Anlage nach Anspruch 1, dadurch gekennzeichnet, daß für
horizontal angeordnete Wärmebehandlungskammern (1A, 1B,
1C, 1D) die Transportvorrichtung (10) einen vertikalen
Tragearm (11a) aufweist, an dem ein horizontaler Tragearm
(11b) verfahrbar angeordnet ist, wobei an dem horizontalen
Tragearm (11b) die Kuppeleinheit (12) horizontal verfahrbar
angeordnet ist.

- 2 -

3. Anlage nach Anspruch 1 oder 2, dadurch gekennzeichnet, daß das Trägersystem (2) freitragend ausgebildet ist.

4. Anlage nach einem der Ansprüche 1 bis 3, dadurch gekennzeichnet, daß das Trägersystem (2) einen Verbindungsungskopf (6) aufweist, der sowohl an die Kuppeleinheit (12) als auch an eine Verbindungseinrichtung (7) der Beschickungseinheit (8) ankuppelbar ausgebildet ist.

5. Anlage nach Anspruch 3, dadurch gekennzeichnet, daß das freitragende Trägersystem (2) einen Einspannkopf (13) aufweist, über den die Neigung des Trägersystems (2) relativ zur Ofenachse einstellbar ist.

6. Anlage nach Anspruch 4 und 5, dadurch gekennzeichnet, daß der Einspannkopf (13) Teil des Verbindungskopfes (6) ist.

7. Anlage nach Anspruch 5, dadurch gekennzeichnet, daß der Einspannkopf (13) zur Verstellung der Neigung des Trägersystems (2) Schraubelemente (15) aufweist.

8. Anlage nach Anspruch 4, dadurch gekennzeichnet, daß der Verbindungskopf (6) ein hakenförmiges Teil aufweist, das sowohl an der Verbindungseinrichtung (7) als auch an der Kuppeleinheit (12) einhakbar ist.

9. Anlage nach Anspruch 8, dadurch gekennzeichnet, daß der Verbindungskopf (6) eine Plattform (6b) aufweist mit einer hakenförmigen Rückwand (6a), die das hakenförmige Teil bildet.

10. Anlage nach Anspruch 9, dadurch gekennzeichnet, daß die Kuppeleinheit (12) eine Plattform (12b) mit einer hiervon vorstehenden Rückwand (12a) aufweist und die Verbindungseinrichtung (7) ebenfalls eine Plattform (7b) aufweist mit zwei vorstehenden, voneinander beabstandeten einen Zwischenraum (14) bildenden Seitenpfosten (7a), wobei der Zwischenraum (14) mindestens geringfügig größer als die Breite der Rückwand (12a) der Kuppeleinheit (12) ist.

11. Anlage nach einem der Ansprüch 8 bis 10, dadurch gekennzeichnet, daß das hakenförmige Teil eine sich verengende Hakenöffnung (16) aufweist.

12. Anlage nach einem der Ansprüche 8 bis 11, dadurch gekennzeichnet, daß die Rückwand (12a) und/oder die Seitenpfosten (7a) an ihrer oberen, nach innen gerichteten Kante eine Abschrägung aufweisen und/oder an ihrer nach außen, zum Verbindungskopf (6) hin gerichteten Seite im unteren Bereich eine sich keilförmig zur Plattform (12b, 7b) hin erweiterend ausgebildete Basis (12c, 7c) aufweisen.

Fig.1

2A
5
1A
13
5
4
3
1B  -1-
6a
2B
7a
6
7
7b
1C
1D
8
5
3
3
7
6
2C
3
3
9
11a
13
5
2D
6a
4
7a
7
7b
14
6b
10
11b  12  6

0158900

1/2

Fig.2A

Fig.2B

Fig.2C

0158900